Europäisches Patentamt

**European Patent Office**

**Office européen des brevets**

(11) Publication number: **0 175 603**
**A2**

# (12) EUROPEAN PATENT APPLICATION

(21) Application number: **85401637.5**

(22) Date of filing: **13.08.85**

(51) Int. Cl.⁴: **G 11 C 15/00**

(30) Priority: **21.08.84 US 642849**

(43) Date of publication of application: **26.03.86**
**Bulletin 86/13**

(84) Designated Contracting States: **DE FR GB IT NL**

(71) Applicant: **FAIRCHILD CAMERA & INSTRUMENT CORPORATION, 464 Ellis Street, Mountain View California 94042 (US)**

(72) Inventor: **Liu, Pin-Wu, 12124 Kirkbrook Drive, Saratoga California 95070 (US)**

(74) Representative: **Chareyron, Lucien et al, SCHLUMBERGER LIMITED Service Brevets 12, place des Etats Unis B.P. 121, F-92124 Montrouge Cedex (FR)**

(54) **Content addressable memory cell.**

(57)   A content addressable memory (CAM) cell signals a match/no-match condition between the content of a cell and the data applied to the comparison circuit by means of a voltage signal. In the associative memory mode, the associative memory comparison circuit compares the data on the bit lines to the data stored in the RAM cells. If there is a predetermined condition of either match or mismatch, a flag line driver transistor coupling the flag line to a bias voltage source such as ground changes its state of conductivity thereby altering the voltage on the flag line. The voltage signal thus produced indicates the match or mismatch condition.

Content Addressable Memory Cell

Background Of The Invention

The invention relates to the field of semiconductor memories for computers, and, more specifically to content addressable or associative memories.

In the traditional access mode data cannot be read or written until the address for the desired cell location is specified. It is desirable in many computer applications to have the capability to interrogate all cells in a memory for a match to particular data. Associative memories provide this non-traditional capability to interrogate all memory cells for a match to a content specification. Associative memories are random access memories which can be accessed in either the traditional address mode or by a search of all locations for a match between data stored therein and given data presented on bit lines running through the memory. In the associative mode each Content Addressable Memory (CAM) cell will signal either a match or no match condition to the content specification.

Conventional CAM cells signaled the match or no-match condition by the presence or absence of flag current in a flag line. This is true even though all the other signals in the circuit are voltages, a situation commonly found in MOS memory circuits. An example of such a conventional CAM cell was described by R. M. Lea in Vol. 8, No. 15 of Electronics Letters at 391 et. seg. (July 27, 1972). The MOS cell described there is capable of read, write and match operations. However, the match or mismatch condition is detected by the presence or absence of current in the word line.

Further the cell requires 14 transistors and therefore consumes a large amount of chip area in integrated form. Further, the increased numbers of MOS transistors in the cell slows access times because of excessive capacitive charging and discharging of the gates of the various MOS transistors.

The match/no-match current in a conventional type CAM cell creates the need for a low impedance sense amplifier to sense the flag current. This type of amplifier is implemented most easily with bipolar transistors. However, the process to create bipolar transistors is different and more complicated than the process to create MOS transistors. Thus, signaling the match condition with a current instead of a voltage substantially increases the manufacturing complexity and therefore increases the cost of producing an MOS memory. Meanwhile, the commercial trend toward increasing functionality on single chips tends to bias designs toward MOS technology because MOS devices are generally smaller and less expensive to make compared to bipolar devices. A difficulty is created thereby which the present invention alleviates.

## Summary Of The Invention

It is a general object of the present invention to provide an improved method and apparatus for a content addressable memory cell.

This and other objects are attained, in accordance with one aspect of the invention by a content addressable memory cell comprising an MOS memory cell coupled to two bit lines and having two signal nodes which are only stable in opposite logical states, said logical states indicating the data stored in said MOS memory cell; a flag line for carrying a match signal consisting of voltage variations indicating a match or no match condition between data presented on said bit lines and data stored in said cell; and associative means coupled to said bit lines, said MOS memory cell signal nodes and said flag line for comparing the data on said bit lines to the data stored in said cell and for causing voltage variation on said flag line to indicate either a match or no match condition.

Another aspect includes a content addressable memory cell comprising an MOS memory cell coupled to two bit lines, a word/flag line and an interrogate line said memory cell for storing data; an associative memory means coupled to said MOS memory cell, said bit lines, said word/flag line and said interrogate line for comparing data stored in said MOS memory cell to data present on said bit lines and for causing the voltage on said word/flag line to change for a predetermined state of match or mismatch between the data compared.

A further aspect comprises a method of comparing data on a bit line to data stored in a RAM cell comprising charging a flag node to a predetermined bias level; sensing the logical state of said bit line; sensing the logical state of the data stored in said RAM cell; charging said flag node to a different bias voltage level upon a predetermined state of match or mismatch between the data on said bit line and the data in said RAM cell; sensing the bias level on said flag node and altering the voltage level on a flag line when the flag node bias level is in a predetermined state.

Brief Description Of The Drawings

Figure 1 is a schematic diagram of a typical prior art CAM cell.

Figure 2 is a schematic diagram of the content addressable memory cell of the invention.

Figure 3 shows an alternative embodiment of the CAM cell.

Figure 4 shows another embodiment for the CAM cell.

Detailed Description Of The Preferred Embodiment

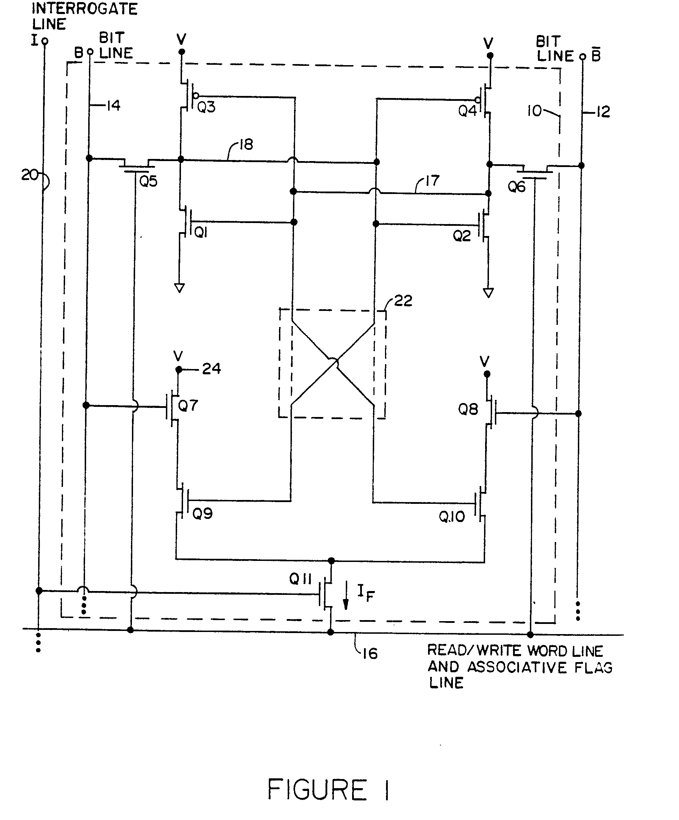

Figure 1 shows the CAM cell of the prior art. Operation of the conventional CAM cell of Figure 1 is as follows.

The data storage element of the CAM cell 10 is comprised of the cross coupled MOS transistors Q1 and Q2 and their associated load transistors Q3 and Q4. Together these transistors comprise a flip-flop or static RAM cell the operation of which is well understood by those skilled in the art. A brief explanation will be included here for completeness. Q1 and Q2 are N-channel MOS transistors by the convention adopted here but they can be PMOS also. Q3 and Q4 are P-channel MOS transistors as indicated by the small circle on their gate terminals in Figure 1. For illustration purposes, assume that a logical 1 can be stored in the CAM cell by latching Q1 in the "on" state while Q2 is latched into the "off" state.

To write a logical 1 into the CAM cell 10, a logical 1 level would be applied to a bit line 12 while a logical 0 level would be applied to a bit line 14. Simultaneously a logical 1 would be applied to a word line 16 thereby turning on steering transistors Q5 and Q6 and coupling the voltage levels on the bit lines 14 and 12 to the gates of the transistors Q1 and Q2 by the conductors 17 and 18.

This causes transistor Q1 to be turned on and transistor Q2 to be turned off. A logical 0 exists on the interrogate line 20 coupled to the gate of the transistor Q11 thereby rendering it non-conductive. After the data is stored in this conventional manner, the voltage level on the word line 16 is driven to logical 0 thereby turning off transistors Q5 and Q6 and isolating the static RAM cell from the bit lines 12 and 14. However, because Q1 is on and Q2 is off, the voltage on the conductor 18 is a logical 0 thereby holding Q2 off while the voltage on the conductor 17 remains at a logical 1 because Q2 remains off after Q6 shuts off thereby holding Q1 in the on state.

When the cell is to be read in the conventional manner, the word line 16 is raised to the logical 1 level again thereby turning the transistors Q5 and Q6 on and coupling the voltages on the conductors 17 and 18 to the bit lines 12 and 14. The logical levels on the conductors 17 and 18, when coupled to the bit lines 12 and 14, change the voltage levels on these bit lines sufficiently to cause sense amplifiers (not shown) coupled to these bit lines to detect the changes and deduce whether there was a logical 1 or a logical 0 stored in the cell. That concludes the discussion of how conventional random access reading and writing occurs in the conventional static RAM cell of Figure 1.

Conventional associative memory operation in the cell of Figure 1 occurs as follows. When data on the bit lines 12 and 14 is to be compared to data stored in the CAM cell 10, the voltage on the interrogate line 20 is raised to a logical 1 level thereby turning on the transistor Q11 through which the flag current will or will not flow depending upon the relative states of the transistors in the CAM cell and the states of the bit lines 12 and 14. The transistors Q7 and Q8 have their gates connected to the bit lines 14 and 12 respectively to sense the logical states of the bit lines and become conductive or remain non-conductive as controlled by the voltage on the bit lines. The transistors Q9 and Q10 have their gates connected to either the conductor 17 or the conductor 18 depending upon the state of the connection junction 22. If the connections in the connection junction 22 are reversed, the existence of a match between the data on the bit lines and the data in the cell will be signaled by the opposite condition of the flag current from the signaling convention before the connections were reversed.

For illustration of the case of a match, assume that conductor 18 is at a logical 1 level and the bit line 14 is also at a logical one level. In associative memory operations, the word line/flag line 16 is maintained at a logical 0 level so the transistors Q5 and Q6 remain off and the word line/flag line 16 sinks all the current that flows through the transistor combinations Q7 and Q9 or Q8 and Q10. If the voltages on the conductor 18 and bit line 14 are both logical 1's, then both Q7 and Q9 will be on and current will flow through them from the node 24 connected to a voltage source, through transistor Q11 and into the word line/flag line 16. Because whenever Q1 is off Q2 must be on and whenever bit line 14 is a logical 1, bit line 12 is a logical 0, transistors Q8 and Q10 will be off thereby blocking all current flow through them to the word line/flag line 16 through the transistor 22.

The above state of affairs indicates a match condition. If the connections in junction 22 are reversed, then the match condition would be indicated by the absence of flag current.

The difficulty with the above circuit for a CAM cell is that the presence or absence of a match is indicated by the presence or absence of a current in the flag line 16. This is very undesirable for the following reason. MOS devices are voltage sensitive. Before an MOS transistor turns from off to on, the voltage on its gate terminal must be driven from below to above its threshold voltage level to create a channel of conductivity improving holes or electrons in the region of the substrate just below the gate which channel region has a conductivity type which matches the conductivity type of the source and drain regions. It is through this channel that current flows between source and drain of an MOS device and can be modulated or switched by the voltage on the gate electrode. Unlike bipolar types of transistors where base current is the controlling factor in controlling the switching or amplification done by the transistor, MOS transistors are not controllable with currents. Accordingly, to use the CAM cell of Figure 1, it is necessary to be able to fabricate bipolar transistors for the sense amplifiers coupled to the bit lines on the same chip as the MOS transistors used for the memory cell. This is exceptionally difficult if not impossible since the processes to make MOS transistors are substantially different and simpler than the processes to make bipolar transistors.

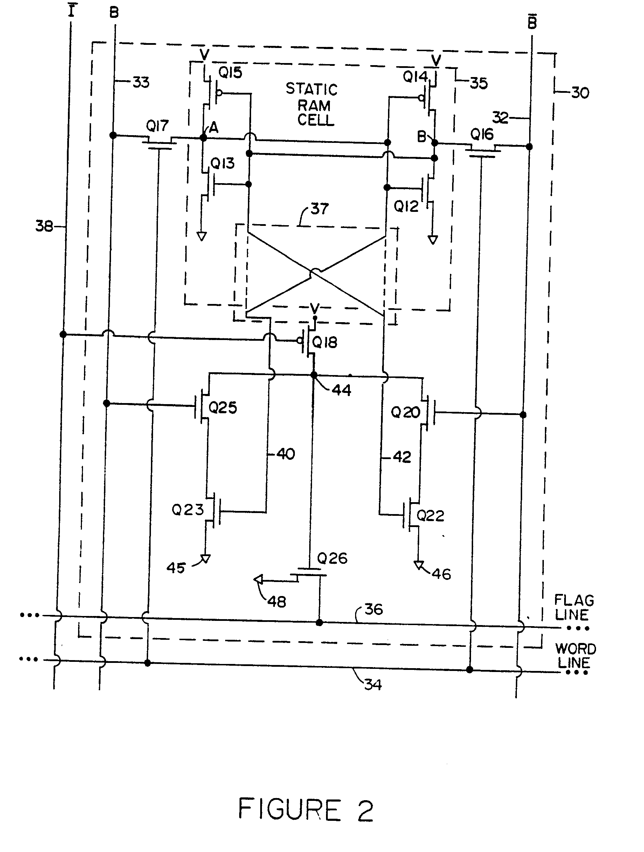

The applicant has invented a method and apparatus to circumvent the above stated problem. The invention is a new CAM cell circuit which signals the presence or absence of a match using voltage variations on the flag line and a method by which this new CAM cell operates. The new CAM cell is shown in Figure 2.

The CAM cell 30 is comprised of a standard cross coupled static RAM cell comprised of MOS transistors Q12, Q13, Q14, Q15 and the associated steering transistors Q16 and Q17. The operation of this cell with respect to random access reading and writing, i.e., the non-associative mode of operation, is entirely conventional, and the description given above with reference to Figure 1 will suffice to explain the conventional aspects of the CAM cell of Figure 2 as well. That is the operative interaction of the transistors Q12, Q13, Q14, Q15, Q16 and Q17 with the bit lines 32 and 33 and the word line 34 are identical with the interactive relationships described with reference to Figure 1.

The difference between the CAM cell of Figure 1 and that of Figure 2 resides in how the associative memory comparison circuitry works. The comparison circuitry consists of transistors Q18, Q20, Q22, Q23, Q25 and Q26 as well as the separate flag line 36 and the interrogate line 38. The transistors Q25 and Q20 have their gates coupled to the bit lines 33 and 32 respectively to sense the state of the data to be compared to the data stored in the static RAM cell 35. When the bit line 33 is a logical 1, the transistor Q25 will be on and the transistor Q20 will be off since the bit lines 33 and 32 are always in opposite logical states. The transistor Q23 has its gate coupled to one of the two cross coupled nodes A or B in the RAM cell 35 by the conductor 40 depending upon the state of connection of the connection junction 37. This connection junction 37 is not a real component of the CAM cell. Its presence on Figures 1 and 2 merely indicates that there is an option regarding which convention is to be adopted for signaling the presence or absence of a match condition. As shown in Figure 2, the gate of the transistor Q23 is connected to the node A, so Q23 will be on when Q13 is off because node A will be a logical 1 for this condition. A similar situation exists for the transistors Q20 and Q22 where the gate of the transistor Q22 is coupled to the node B by the conductor 42 and the gate of the transistor Q20 is coupled to the bit line 32.

The two branches defined by the transistor pairs Q25/Q23 and Q20/Q22 are joined at a common flag node 44 and each branch forms a switchable path to ground (or some other bias voltage source represented by the nodes 45 and 46). The flag node is charged by the action of the transistor Q18 and can be discharged by the action of either of the transistor pairs Q25/Q23 or Q20/Q22 in either of the two branches if voltage conditions are right to form a path to either of the bias sources 45 or 46. That is, the transistor Q18 and the transistor pairs Q25/Q23 and Q22/Q20 coupled with the interrogate line 38 and the flag line 36 and a flag line driver transistor Q26 form an associative memory comparison circuit that works as follows.

When an associative memory comparison is desired, the data to be compared to the contents of the RAM cell 35 is placed on the bit lines 33 and 32 by driver circuitry which is not shown. The word line 34 is kept low or logical 0 to keep the transistors Q17 and Q16 off so as to isolate the data on the bit lines from the data stored on the nodes A and B in the RAM cell 35. Simultaneously, the interrogate line is driven to a proper state to turn on the flag node driver transistor Q18 so as to render Q18 conductive thereby connecting the bias supply V to the flag node 44 through whatever resistivity is represented by the channel of the transistor Q18. The transistor pairs Q25/Q23 or Q20/Q22 then discharge the node 44 or leave it charged depending upon the state of the bit lines 32 and 33 compared to the data in the RAM cell 35. For example, when the bit line 33 is a logical 1 and the node A is charged to a logical 1 by the bistable state of the RAM cell 35, then both Q25 and Q23 will be on, and the node 44 will be discharged to the level of the bias supply source 45. Because the node 44 is discharged, Q26 will not turn on to discharge the flag line 36 which, in the embodiment of Figure 2, has been precharged to a logical 1 level and remains there. If, however, there had been a mismatch, either Q25 would be on and Q23 would be off or vice versa and the source would be true for Q20 and Q22.

This would leave node 44 charged and would turn on Q26 thereby discharging the flag line 36. Similar description applies to the action of Q20 and Q22 because of the complementary nature of the signals on the bit lines 33 and 32 and on the nodes A and B.

Those skilled in the art will appreciate that the sign and magnitude of the voltage supply V coupled to Q18 must be appropriate to turn on Q26 for signaling a matched condition. It will also be appreciated by those skilled in the art that the flag line 36 can be precharged to a logical 1 and Q26 can discharge it to ground or charge it to a different voltage level of the supply 48 upon a match or mismatch convention depending upon the convention selected. Alternatively, the voltage supply 48 can be a logical 1 and the transistor Q26 can connect it to the flag line when Q26 is turned on. Further, it will be appreciated by those skilled in the art that Q25 and Q23 are interchangeable as are Q20 and Q22.

It will also be appreciated by those skilled in the art that Q14 and Q15 can be any conventional MOS load device or high resistance polysilicon resistors can be substituted. Further any conventional MOS or CMOS inverter design can be cross coupled as shown in Figure 2 to serve as the RAM cell 35 in the CAM cell of Figure 2. Such conventional designs are described in detail in Millman, Microelectronics, at pp.253-59,263-264 (1979 McGraw Hill Book Company) and hereby incorporated by reference. CMOS inverters are preferred because of their desirable properties including low power dissapation, high noise immunity, low temperature dependence and increased speed over MOS gates as well as the need for only one power supply as opposed to the two supplies needed for some MOS inverters such as those

with enhancement mode driver transistors, and enhancement mode load transistors operating in the non-saturated region.

Figure 2 shows the preferred embodiment for the CAM cell where Q18 is a P channel MOS transistor and the interrogate line 38 is driven to a logical 0 level for associative memory operations thereby turning on Q18, but maintained at a logical 1 level for normal read/write operations.

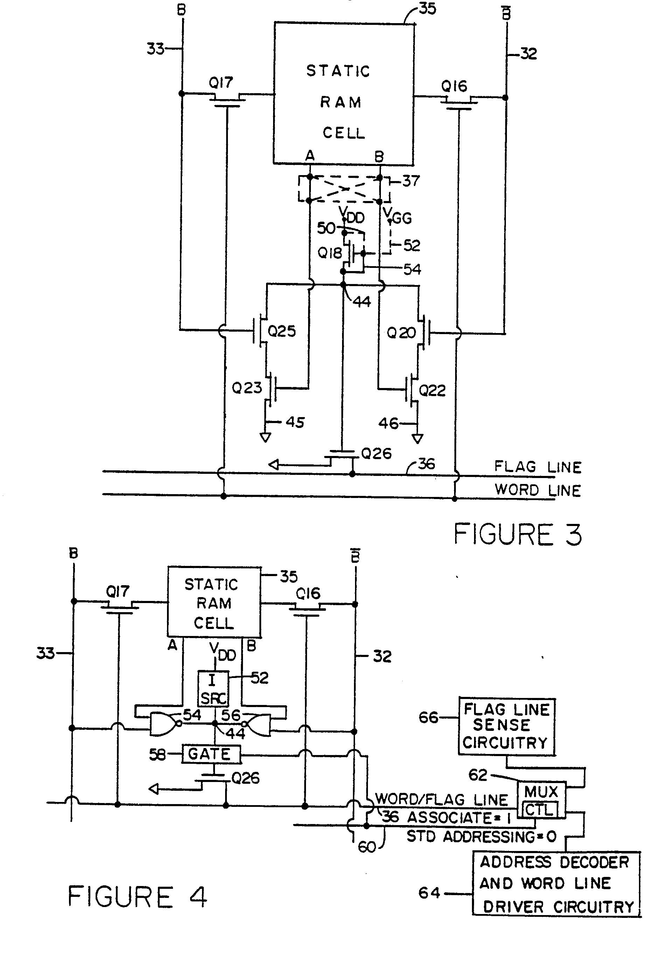

Figure 3 shows an alternative embodiment for the CAM cell wherein Q18 is a depletion mode NMOS transistor with its gate connected to its source. The gate to source bias voltage in this embodiment is zero which means that the transistor can be operating in either the non-saturated or the saturated region of its drain characteristic curve depending upon the magnitude of the bias voltage source $V_{DD}$. Effectively, Q18 will be operating as a constant current source in charging the flag node 44 and the gate capacitance of the flag driver transistor Q26. Thus the flag node and the gate of the transistor Q26 will always be charged to a bias voltage level equal to $V_{DD}$ until one of the switching branches of the comparison circuitry, i.e., Q25/Q23 or Q20/Q22, connects the flag node 44 to ground or the second bias voltage source 45 and 46 upon a match (or mismatch condition).

Because there is no interrogate line in this embodiment, the flag line will naturally indicate a match condition when normal random access read or write operations are being performed because a match occurs every time a random access read or write is performed. However, these indications can be ignored, and the flag line 36 can be examined only when associative memory operation is desired. Those skilled in the art can easily design circuitry to examine the flag line voltage variations only when associative memory operation is desired.

Of course the foregoing assumes that the bias source $V_{DD}$ is chosen such that the voltage buildup on the gate of Q26 exceeds its threshold voltage.

Further embodiments are represented by the optional connections 50 and 52 shown in phantom in Figure 3 connected to the gate of Q18 in Figure 3. The connection 50 represents an option wherein an enhancement mode NMOS transistor Q18 is used with its drain to source voltage equal to its gate to source voltage such that it operates in the saturation region. With the gate of Q18 connected to a bias voltage source $V_{GG}$ by the optional connection 52, Q18 will operate in the nonsaturation region if $V_{GG}$ is greater than $V_{DD}$ plus the threshold voltage of Q18.

In addition to the above described embodiments, an NMOS Q18 could be used with its gate connected to the interrogate line 38, i.e., an NMOS transistor could be substituted for Q18 in Figure 2. Further, any of the embodiments of Figure 3 could use a PMOS Q18 instead of the NMOS Q18 shown in Figure 3 biased in either the saturation or non-saturation region. Further, either enhancement or depletion mode devices of either channel type may be used for Q18. These different devices have slightly different characteristics for drain current plotted as a function of gate to source voltage and drain to source voltage. Those skilled in the art will appreciate the differences in current flowing into the flag node 44 under various operating conditions which will result from the above noted substitutions. The type of transistor used, the gate to source bias and the mode in which the MOS transistor is used will not change the fundamental concept however. That concept is that the flag node must be charged by some current source during associative memory operations. The flag driver transistor gate is controlled by the charge on the flag node which can be discharged by the action of either of two comparison circuits which form two parallel paths to ground or a bias source which has a voltage less than the threshold voltage of the flag transistor. These two comparison circuit branches open a path to ground or the second bias source when there is either a match or mismatch condition depending upon the convention selected.

Figure 4 shows an alternative embodiment for the CAM cell utilizing a single conductor for both the word line and the flag line where the single conductor is time shared by two different functional driving circuits through a multiplexer. The static RAM cell 35 is shown schematically and can be any type of RAM cell. Note in Figure 4, that the addressing or steering transistors Q17 and Q16 have their gates connected to the word/flag line 36. The transistor Q18 in the Figure 2 and 3 embodiments is represented a current source 52. Those skilled in the art will appreciate that any of the biasing and gate coupling arrangements discussed above in connection with Figures 2 and 3 can be used for the current source 52. Note also that in Figure 4, the two switching paths to the second bias voltage sources 45 and 46 have been replaced with NAND gates 54 and 56. These NAND gates are of the open drain variety and have an internal path to ground. The open drain is coupled to the flag node 44, and the inputs for each are one of the bit lines 33 or 32 and one of the signal nodes A or B. When both inputs to either NAND gate are logical 1's, which can be in case of either a match or mismatch depending upon the convention selected, the output of the NAND gate goes to logical 0 thereby discharging the flag node and turning off the flag line driver transistor Q26. The gate 58 is coupled in the conductor 58 to prevent the transistor Q26 from turning on during normal read and write operations when a match occurs thereby grounding the word/flag line 36 while it is supposed to be in the logical 1 state to hold the transistors Q17 and Q16 on for the read or write operation. The open or closed status of the gate 58 is controlled by the logical state of a control line 60 which controls a conventional multiplexer 62 driving the word/flag line 36. This signal on the line 60 can be read to determine if the CAM cell is in an associative mode or a normal random access mode.

The multiplexer 62 can be any conventional design which can switch either of two inputs to be coupled with a single output. In this case the output is the word/flag line 36. One input is coupled to a conventional address decoder and word line driver circuit 64, while the other input is coupled to conventional sense circuitry 66. This sense circuitry 66 can be any design which can detect changes in the voltage on the word/flag line 36 during associative memory comparison operations. The control line 60 controls which of these two inputs is coupled at any particular time to the word/flag line 36. This control line comes from any logic circuit in the system (not shown) using the CAM cell which controls whether associative memory or conventional memory operations are

0175603

occurring.

The apparatus of Figures 2-4 all utilize a common inventive method comprised of charging a flag mode to a predetermined level of bias and sensing the logical states of the bit lines and the data stored in the RAM cell. If there is a predetermined state of match or mismatch depending upon the convention chosen, then the flag mode is discharged or charged to different bias level again depending upon the convention chosen. Finally, the bias level of the flag mode is sensed and the voltage level of the flag line is altered when the bias level on the flag mode is in a predetermined state.

Those skilled in the art will appreciate that other changes may be made to the embodiments described above which do not depart from or change the function of individual elements of the invention or change the fundamental interaction of those elements. All such modifications are intended to be include within the scope of the claims appended hereto.

WHAT IS CLAIMED IS:

1.   A content addressable memory cell characterized
by:

an MOS memory cell coupled to two bit lines and
having two signal nodes which are only stable in
opposite logical states, said logical states indicating
the data stored in said MOS memory cell;

a flag line for carrying a match signal consisting
of voltage variations indicating a match or no match
condition between data presented on said bit lines and
data stored in said cell; and

associative means coupled to said bit lines, said
MOS memory cell signal nodes and said flag line for
comparing the data on said bit lines to the data stored
in said cell and for causing voltage variation on said
flag line to indicate either a match or no match
condition.

2.   The memory cell of claim 1 characterized in
that said MOS memory cell includes means to allow normal
read and write random access to the memory cell.

3.   The memory cell of claim 1 or 2 characterized
in that said associative means includes a separate flag
line and word line.

4.   The memory cell of claim 1, 2 or 3
characterized by a flag driver means to alternatively
couple said flag line to a predetermined source of bias
voltage or leave the flag line uncoupled to any other
bias voltage source such that it can maintain its
current signal voltage level depending upon the match or
mismatch state of the data on the bit lines compared to
the data stored in said MOS memory cell.

5. The memory cell of claim 4 characterized in that said flag driver means is an MOS transistor having a gate terminal connected to a flag node which is either charged or discharged by means for comparing data on said bit lines to data stored in said MOS memory cell.

6. The memory cell of claim 4 characterized in that said comparing means includes an MOS transistor having its gate coupled to said interrogate line and its source and drain terminals coupled between said flag node and a voltage source.

7. The memory cell of any one of claims 1-6 characterized in that each said signal node of said MOS memory cell is individually coupled to one of the gates of said first and second MOS transistors included in said comparing means.

8. The memory cell of claim 5, 6 or 7 characterized in that said flag node is coupled to a bias voltage through either of two switching branches.

9. The memory cell of claim 8 characterized in that each of said switching branches contains one of said first or second MOS transistors and an additional MOS transistor having its source and drain coupled between said flag node and said first or said second MOS transistor, said additional MOS transistor having its gate terminal coupled to one of said bit lines.

10. The memory cell of claim 1 characterized in that said associative means includes:
an MOS transistor biased into its non-saturated region coupled between a first bias voltage source and a flag node to cause said flag node to be biased to a predetermined voltage;

switch path means for conditionally coupling said flag node to a second bias voltage source through either two parallel paths to said second bias voltage source so as to alter the bias voltage on said flag node or leave the bias voltage on said flag node unchanged depending upon the matched or unmatched state of the data on said signal nodes compared to the data on said bit lines; and

flag line driver means coupled between said flag node and said flag line for either altering or leaving unchanged the bias voltage level on said flag line depending upon the state of the bias voltage on said flag node.

11. The memory cell of claim 1 characterized in that said associative means includes:

an MOS transistor coupled between a first bias voltage source and a flag node said transistor biased into the saturation region so as to cause said flag node to biased at a predetermined voltage level;

switching path means for conditionally coupling said flag node to a second bias voltage source through either of two parallel paths to said second bias voltage source so as to alter the bias voltage on said flag node or leave the bias voltage on said flag node unchanged depending upon the matched or unmatched state of the data on said signal nodes compared to the data on said bit lines; and

flag line driver means coupled between said flag node and said flag line for either altering or leaving unchanged the bias voltage level on said flag line depending upon the state of the bias voltage on said flag node.

12. The memory cell of claim 10 or 11 characterized in that said switching path means is comprised of two branches between said flag node and said second bias voltage source, each said branch comprised of a first MOS transistor having its drain coupled to said flag node and its gate coupled to one of said bit lines and its source coupled to the drain of a second MOS transistor which has its gate coupled to one of said signal nodes and its source coupled to said second bias voltage source.

13. The memory cell of claim 10 or 11 characterized in that said switching path means comprises two NAND gates each having its output coupled to said flag node and each having one input coupled to one of said bit lines and the other input coupled to one of said signal nodes.

14. A content addressable memory cell characterized by:
an MOS memory cell coupled to two bit lines, a word/flag line and an interrogate line said memory cell for storing data;
an associative memory means coupled to said MOS memory cell, said bit lines, said word/flag line and said interrogate line for comparing data stored in said MOS memory cell to data present on said bit lines and for causing the voltage on said word/flag line to change for a predetermined state of match or mismatch between the data compared.

15. The memory cell of claim 14 characterized in that said associative memory means comprises:
an MOS transistor having its gate coupled to said interrogate line and having its source and drain coupled between a first bias voltage source and a flag node to cause said flag node to be biased to a predetermined voltage upon a predetermined condition of said interrogate line;

switching path means for conditionally coupling said flag node to a second bias voltage source through either of two parallel paths to said second bias voltage source so as to alter the bias voltage on said flag node or leave the bias voltage on said flag node unchanged depending upon the matched or unmatched state of the data on said signal nodes compared to the data on said bit lines;

word/flag line driver means coupled between said flag node and said word/flag line for causing a predetermined change in the bias voltage level on said word/flag line depending upon the state of the bias voltage on said flag node; and

multiplexer means coupled to said word/flag line for causing it to function as a normal word line in a static RAM cell during normal random access read or write operations but to cause said word line to act as a flag line during associative memory operations.

16. A method of comparing data on a bit line to data stored in a RAM cell characterized by:

charging a flag node to a predetermined bias level;

sensing the logical state of said bit line;

sensing the logical state of the data stored in said RAM cell;

charging said flag node to a different bias voltage level upon a predetermined state of match or mismatch between the data on said bit line and the data in said RAM cell;

sensing the bias level on said flag node and altering the voltage level on a flag line when the flag node bias level is in a predetermined state.

0175603

1/3

FIGURE I

FIGURE 2

3/3

FIGURE 3

FIGURE 4